# EUROPEAN PATENT APPLICATION

(11) **EP 1 930 471 A2**
(43) Date of publication of application: **11.06.2008**
(21) Application number: 07115064.3
(22) Date of filing: 28.08.2007
(51) Int. Cl.: C23C 18/18, C23C 18/31, C25D 13/02, C25D 13/20, H01L 51/00, C23C 28/00

(54) **Barrier layer, composite article comprising the same, electroactive device, and method**

(30) Priority: 06.12.2006 US 567313
(71) Applicant: General Electric Company, Schenectady, NY 12345 (US)
(72) Inventor: Lewis, Larry Neil, Scotia, NY 12302 (US); Erlat, Ahmet Gun, Clifton Park, NY 12065 (US); Yan, Min, Ballston Lake, NY 12019 (US); Breitung, Eric Michael, New York, NY 10023 (US); Duggal, Anil Raj, Niskayuna, NY 12309 (US)
(74) Representative: Szary, Anne Catherine

(57) **Abstract**

A composite article is provided comprising (i) a substrate (14), (ii) either a conductive layer or a catalyst layer disposed on at least one surface of the substrate (14); and (iii) a barrier layer (16) disposed on the conductive layer or catalyst layer; wherein the barrier layer (16) comprises a barrier coating and at least one repair coating disposed on the barrier coating, wherein the repair coating comprises a metal or a metal based compound. An electroactive device comprising the composite article (10) is also provided.

## Description

### BACKGROUND

The invention relates generally to barrier layers, composite articles comprising the barrier layers, and methods of making the same. The invention also relates to devices sensitive to chemical species and especially electroactive devices comprising the composite articles.

Electroactive devices such as electroluminescent (EL) devices are well-known in graphic display and imaging art. EL devices have been produced in different shapes for many applications and may be classified as either organic or inorganic. Organic electroluminescent devices, which have been developed more recently, offer the benefits of lower activation voltage and higher brightness, in addition to simple manufacture and thus the promise of more widespread applications compared to inorganic electroluminescent devices.

An organic electroluminescent device is typically a thin film structure formed on a substrate such as glass, transparent plastic, or metal foil. A light-emitting layer of an organic EL material and optional adjacent semiconductor layers are sandwiched between a cathode and an anode. Conventional organic electroluminescent devices are built on glass substrates because of a combination of transparency and low permeability to oxygen and water vapor. However, glass substrates are not suitable for certain applications in which flexibility is desired. Flexible plastic substrates have been used to build organic electroluminescent devices. However, the plastic substrates are not impervious to environmental factors such as oxygen, water vapor, hydrogen sulfide, SOₓ, NOₓ, solvents, and the like, resistance to which factors is often termed collectively as environmental resistance. Environmental factors, typically oxygen and water vapor permeation, may cause degradation over time and thus may decrease the lifetime of the organic electroluminescent devices in flexible applications. Previously, the issue of oxygen and water vapor permeation has been addressed by applying alternating layers of polymeric and ceramic materials over the substrate. The fabrication of such alternating layers of polymeric and ceramic materials requires multiple steps and hence is time consuming and uneconomical.

Therefore, there is a need to improve the environmental resistance of substrates in electroactive devices such as organic electroluminescent devices and to develop a method of doing the same, in a manner requiring a minimal number of processing steps.

### BRIEF DESCRIPTION

According to one embodiment of the invention there is provided a composite article comprising: (i) a substrate having a surface; (ii) either a conductive layer or a catalyst layer disposed on at least one surface of the substrate; and (iii) a barrier layer disposed on the conductive layer or catalyst layer; wherein the barrier layer comprises a barrier coating and at least one repair coating disposed on the barrier coating, wherein the repair coating comprises a metal or a metal based compound

In another embodiment of the invention there is provided a method of making a composite article comprising the steps of: (i) providing a flexible substrate having a surface; (ii) depositing either a conductive layer or a catalyst layer on at least one surface of the substrate; (iii) depositing a barrier coating on the conductive layer or catalyst layer; (iv) and disposing a repair coating on the barrier coating by exposing the barrier coating to at least one metal ion or charged particle species in at least one electrophoretic deposition process cycle or at least one electroless plating process cycle.

In another embodiment of the invention there is provided a light emitting device comprising: (i) a flexible, substantially transparent substrate having a surface; (ii) either a conductive layer or a catalyst layer disposed on at least one surface of the substrate; (iii) a barrier layer disposed on the conductive layer or catalyst layer; and (iv) at least one organic electroluminescent layer disposed between two electrodes; wherein the barrier layer comprises a barrier coating and at least one repair coating disposed on the barrier coating, wherein the repair coating comprises a metal or a metal based compound deposited in at least one electrophoretic deposition process cycle or at least one electroless plating process cycle.

In yet another embodiment of the invention there is provided a composite article comprising: (i) either a conductive layer or a catalyst layer; and (ii) a barrier layer disposed on the conductive layer or catalyst layer; wherein the conductive layer is selected from the group consisting of indium tin oxide, tin oxide, indium oxide, zinc oxide, cadmium oxide, alumimum oxide, gallium oxide, indium zinc oxide, tungsten oxide, molybdenum oxide, titanium oxide, vanadium oxide, aluminum, platinum, gold, silver, lanthanide series metals, an alloy thereof, and combinations thereof; wherein the catalyst layer is selected from the group consisting of a noble metal, palladium, platinum, rhodium, an alloy thereof, and combinations thereof; wherein the barrier layer comprises a barrier coating and at least one repair coating disposed on the barrier coating, wherein the repair coating comprises a metal or a metal based compound deposited on the barrier coating in at least one electrophoretic deposition process cycle or at least one electroless plating process cycle, wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof; wherein the repair coating comprises a metal selected from the group consisting of nickel and copper or a metal based compound selected from the group consisting of a metal halide, a metal oxide, a metal sulfide, a metal nitride, a metal carbide, a metal boride, silica, titania, alumina, zirconia, and combinations thereof; and wherein the barrier layer has a water vapor transmission rate through the barrier layer of less than about 1x10⁻² g/m²/day, as measured at 25°C and with a gas having 50 percent relative humidity.

### BRIEF DESCRIPTION OF THE DRAWINGS

These and other features, aspects, and advantages of the present invention will become better understood when the following detailed description is read with reference to the accompanying drawings wherein:
Figure 1 shows a composite article comprising a barrier layer and a substrate layer according to one embodiment of the present invention.
Figure 2 shows a composite article comprising a barrier layer and a substrate layer and further comprising an organic electroluminescent layer according to another embodiment of the invention.
Figure 3 shows a composite article comprising a barrier layer and a substrate layer and further comprising an organic electroluminescent layer in yet another embodiment of the invention.
Figure 4 shows a composite article comprising a barrier layer and a substrate layer and further comprising a light scattering layer according to yet another embodiment of the invention.

### DETAILED DESCRIPTION

In the following specification and the claims which follow, reference will be made to a number of terms which shall be defined to have the following meanings. The singular forms "a", "an" and "the" include plural referents unless the context clearly dictates otherwise. The phrases "environmental resistance" and "resistance to diffusion of chemical species" are used interchangeably.

According to one embodiment of the invention, a composite article is provided comprising a conductive layer disposed over at least a portion of a surface of a substrate or other layer or layers to be protected and a barrier coating disposed over the surface of the conductive layer. According to another embodiment of the invention, a composite article is provided comprising a catalyst layer disposed over at least a portion of a surface of a substrate or other layer or layers to be protected and a barrier coating disposed over the surface of the catalyst layer. A repair coating is disposed on the barrier coating to form a barrier layer. Composite articles having the repair coating on the barrier coating as described in embodiments of the invention have improved resistance to diffusion of chemical species and, hence, extended life, rendering them more commercially viable.

In some embodiments the substrate material may be flexible and/or substantially transparent. The substrate may be a single piece or a structure comprising a plurality of adjacent pieces of different materials. Illustrative substrate materials comprise organic polymeric resins such as, but not limited to, a polyethylene terephthalate (PET), a polyacrylate, a polynorbornene, a polycarbonate, a silicone, an epoxy resin, a silicone-functionalized epoxy resin, a polyester such as MYLAR® (available from E. I. du Pont de Nemours & Co.), a polyimide such as KAPTON® H or KAPTON® E (available from du Pont), APICAL® AV (available from Kaneka High-Tech Materials), UPILEX® (available from Ube Industries, Ltd.), a polyethersulfone, a polyetherimide such as ULTEM® (available from General Electric Company), a poly(cyclic olefin), or a polyethylene naphthalate (PEN). Other illustrative substrate materials comprise a glass, a metal or a ceramic. Combinations of substrate materials are also within the scope of the invention.

In certain embodiments additional layers may be disposed on the substrate prior to application of the barrier coating. In one embodiment of the invention a planarizing layer is provided on the substrate before deposition of the conducting layer. The planarizing layer composition comprises at least one resin. In a further aspect of the invention the resin is an epoxy based resin. For example, the resin could be a cycloaliphatic epoxy resin such as, but not limited to, 3,4-epoxycyclohexylmethyl-3,4-epoxycyclohexylcarboxylate. Illustrative examples of cycloaliphatic epoxy resins include, but are not limited to, Dow ERL4221, ERL4299, ERLX4360, CYRACURE® UVR-6100 series and cycloaliphatic diepoxy disiloxanes such as those available from Silar Labs. The epoxy based resins may impart increased surface durability, for example, by improving resistance to scratch and damage that may likely happen during fabrication or transportation. Moreover, the siloxane portion of certain diepoxies may be easily adjusted in length and branching to optimize desired properties. In another aspect of the present invention, the resin is an acrylic based resin.

The planarizing layer composition may further comprise at least one flexibilizing agent, adhesion promoter, surfactant, catalyst or combinations thereof. A flexibilizing agent helps make the planarizing layer less brittle and more flexible by reducing the cracking or peeling and generally reducing the stress the coating applies to the underlying substrate. Illustrative examples of flexibilizing agents include, but are not limited to, Dow D.E.R.® 732 and 736, cyclohexane dimethanol, Celanese TCD alcohol DM, and King Industries K-FLEX® 148 and 188. An adhesion promoter may help to improve adhesion between the substrate and the barrier coating. For example, an adhesion promoter such as an organic silane coupling agent binds to the surface of the substrate and the subsequent barrier coating applied over the substrate. It is believed that a surfactant helps lower the surface energy of the barrier coating, allowing it to wet a substrate, and level better, providing a smoother, more uniform coating. Illustrative examples of surfactants include, but are not limited to, OSI SILWET® L-7001 and L-7604, GE SF1188A, SF1288, and SF1488, BYK-Chemie BYK®-307, and Dow TRITON® X.

In still another aspect of the present invention the planarizing layer may be cured. Illustrative curing methods include radiation curing, thermal curing, or combinations thereof. In one specific example, the radiation curing comprises ultraviolet (UV) curing. Other illustrative curing methods include anhydride or amine curing. Illustrative examples of UV curing agents include, but are not limited to, Dow CYRACURE® UVI-6976 and UVI-6992, Ciba IRGACURE® 250, and GE UV9380C. Non-limiting examples of thermal curing catalysts comprise King Industries CXC-162, CXC-1614, and XC-B220, and 3M FC520

Other optional additives can be incorporated into the planarizing layer to tailor its properties. Illustrative additives may comprise a UV catalyst, a UV absorber such as Ciba TINUVIN®, a UV sensitizer such as isopropylthioxanthone or ethyl dimethoxyanthracene, an antioxidant such as Ciba Geigy's IRGANOX® hindered amine complexes, and leveling agents such as BYK-Chemie BYK®-361. Siloxane additives can be included to make the planarizing layer more scratch resistant

Illustrative barrier coating compositions comprise those selected from organic materials, inorganic materials, ceramic materials, and any combination thereof. In one example, these materials are recombination products derived from reacting plasma species and are deposited on the conductive or catalyst layer. Organic barrier coating materials typically comprise carbon and hydrogen, and optionally other elements, such as oxygen, sulfur, nitrogen, silicon and like elements, depending on the types of reactants. Suitable reactants that result in organic compositions in the barrier coating comprise straight or branched alkanes, alkenes, alkynes, alcohols, aldehydes, ethers, alkylene oxides, aromatics, or like species, having up to about 15 carbon atoms. Inorganic and ceramic barrier coating materials typically comprise oxides, nitrides, borides, or any combinations thereof, of elements of Groups IIA, IIIA, IVA, VA, VIA, VIIA, IB or IIB; metals of Groups IIIB, IVB, or VB, or rare earth elements. For example, a barrier coating comprising silicon carbide can be deposited on a conductive or catalyst layer by recombination of plasmas generated from silane and an organic material, such as methane or xylene. A barrier coating comprising silicon oxycarbide can be deposited from plasmas generated from silane, methane, and oxygen, or silane and propylene oxide, or from plasma generated from organosilicone precursors, such as tetraethoxy orthosilane (TEOS), hexamethyl disiloxane (HMDS), hexamethyl disilazane (HMDZ), or octamethyl cyclotetrasiloxane (D4). A barrier coating comprising silicon nitride can be deposited from plasmas generated from silane and ammonia. A barrier coating comprising aluminum oxycarbonitride can be deposited from a plasma generated for example from a mixture of aluminum tartrate and ammonia. Other combinations of reactants may be chosen to obtain a desired barrier coating composition. A graded composition of the barrier coating may be obtained by changing the compositions of the reactants fed into the reactor chamber during the deposition of reaction products to form the coating.

In other embodiments the barrier coating may comprise hybrid organic/inorganic materials or multilayer organic/inorganic materials. In still other embodiments the organic materials may comprise an acrylate, an epoxy, an epoxyamine, a siloxane, a silicone, or the like. In some embodiments barrier coatings comprising organic materials may be deposited using known methods such as, but not limited to, spin coating, flow coating, gravure or microgravure process, dip coating, spray coating, vacuum deposition, plasma enhanced chemical vapor deposition, or like methods. Metals may also be suitable for the barrier coating in applications where transparency is not required.

The thickness of the barrier coating is in one embodiment in the range from about 10 nanometers (nm) to about 10,000 nm, in another embodiment in the range from about 10 nm to about 1000 nm, and in still another embodiment in the range from about 10 nm to about 200 nm. It may be desirable to choose a barrier coating thickness that does not impede the transmission of light through the conductive or catalyst layer and substrate combination. In one embodiment the reduction in light transmission is less than about 20 percent, in another embodiment less than about 10 percent, and in still another embodiment less than about 5 percent, compared to a substantially transparent conductive or catalyst layer and substrate combination. In some embodiments the barrier coating does not affect the flexibility of the conductive or catalyst layer and substrate combination.

The barrier coating may be formed on a surface of the conductive or catalyst layer by one of many known deposition techniques, such as, but not limited to, plasma enhanced chemical vapor deposition (PECVD), radio frequency plasma enhanced chemical vapor deposition (RF-PECVD), expanding thermal-plasma chemical vapor deposition, reactive sputtering, electron-cyclotron-resonance plasma enhanced chemical vapor deposition (ECRPECVD), inductively coupled plasma enhanced chemical vapor deposition (ICPECVD), sputter deposition, evaporation, atomic layer deposition, or combinations thereof. In some embodiments the barrier coating may encapsulate either the conductive or catalyst layer and substrate combination, or the conductive or catalyst layer and substrate combination and one or more other layers comprising a composite article, or an electroactive device as described in embodiments of the invention.

The barrier coating obtained as described above may contain defects such as voids. Such voids may comprise pores, pinholes, cracks, and the like. The barrier coating may have a single defect or multiple defects. The defects may allow permeation of oxygen, water vapor, or other chemical species through an area of the defect. The infiltration of oxygen and water vapor through the barrier coating may damage a surface of the substrate, or may damage the barrier coating itself which may eventually damage the substrate, in either case resulting in damage to an electroactive device comprising the substrate. Minimizing the defects in the barrier coating may improve protection to the underlying substrate. Defects such as pinholes are typically deep and in some embodiments may extend across the thickness of the barrier coating, or in certain embodiments may just stop within the barrier coating. The pinhole defects that extend across the thickness of the barrier coating may expose the underlying substrate to attack by reactive species existing in the environment.

According to embodiments of the present invention at least one repair coating is disposed over the barrier coating to minimize the defects in the barrier coating. In one embodiment the repair coating is disposed on the barrier coated conductive layer and substrate combination using electrophoretic deposition. In another embodiment the repair coating is disposed on the barrier coated catalyst layer and substrate combination using electroless plating. Electrophoretic deposition and electroless plating of the repair layer function to fill the defects in the barrier coating. As used herein the term "fill" implies filling or covering of the defects as well as coating of the defects. When filling defects in the barrier coating that penetrate to the substrate surface, the repair coating may be in contact with the substrate as well as with the barrier coating.

The electrophoretic deposition process comprises providing a non-neutral dispersion or solution of charged particles in a solvent and applying a DC voltage wherein one electrode (herein after sometimes referred to as the active electrode) is the part or surface being coated and the other electrode is in contact with the solvent. The charged particles are attracted to the electrode with the opposite polarity and are attracted by a greater electric field the closer they are to the active electrode. Deposition of the charged particles provides the repair coating on the barrier coating.

In embodiments of the present invention the electrophoretic deposition process comprises a step of depositing a conductive layer of material onto a substrate or onto a previously formed layer on a substrate, such as a planarizing layer, to form the active electrode. In some embodiments at least a portion of the substrate or previously formed layer is masked so that the conductive layer does not completely cover it. The masked portion is subsequently unmasked to serve as an electrode contact. Illustrative examples of materials suitable for conductive layers comprise indium tin oxide, tin oxide, indium oxide, zinc oxide, cadmium oxide, alumimum oxide, gallium oxide, indium zinc oxide, tungsten oxide, molybdenum oxide, titanium oxide, or vanadium oxide, aluminum, platinum, gold, silver, lanthanide series metals, or alloys thereof or any combination thereof. The thickness of the conductive layer is typically that thickness effective to permit electrophoretic deposition of at least one repair coating. In illustrative embodiments the thickness of the conductive layer is in a range of about 10 nm to about 1000 nm, particularly in a range of about 10 nm to about 500 nm, and more particularly in a range of about 10 nm to about 150 nm. In particular embodiments the conductive layer is such that said layer is substantially transparent, wherein the term "substantially transparent" is as defined herein below. In other particular embodiments the conductive layer is such that the conductive layer and substrate combination is substantially flexible. The conductive layer may be applied using methods known in the art including, but not limited to, sputtering, thermal evaporation, electron beam evaporation, and like methods.

There is no particular limitation on the charged particles that may serve as the repair coating. In some embodiments the charged particles are metal-comprising particles. Illustrative examples of metal-comprising particles include, but are not limited to, a metal, a metal halide, a metal oxide, a metal sulfide, a metal nitride, a metal carbide, a metal boride, or the like, or combinations thereof. In particular embodiments the charged particles are metal oxide particles such as, but not limited to, silica, titania, alumina, zirconia, or the like, or combinations thereof. Typical size of the charged particles is such that the particles are effective to fill defects in the barrier coating. In some illustrative embodiments the size of the charged particles is in the range of from about 0.5 nm to about 100 nm, and particularly in the range of from about 0.5 nm to about 20 nm. There is no particular limitation on the concentration of charged particles in solution or dispersion provided that the solution or dispersion may serve to provide a repair coating on the barrier coating in an electrophoretic deposition process. Also the time and amplitude of DC voltage application to the solution or dispersion of charged particles is not particularly limited provided that a repair coating may be provided on the barrier coating in an electrophoretic deposition process. Optimum values for these and other parameters associated with the electrophoretic deposition process may be readily determined by those skilled in the art.

The electrophoretic deposition process may be performed using methods known in the art, for example in a batch process, continuous process, or semi-continuous process. In a particular embodiment a continuous or semi-continuous roll-to-roll process is employed.

Electroless plating uses a redox reaction to deposit metal on an object using a metal ion solution without the use of electrical energy. Because it allows a constant metal ion concentration to bathe all parts of the object, it deposits metal evenly along edges, inside holes, and over irregularly shaped objects which are difficult to plate evenly with electroplating. The electroless plating process comprises providing a metal ion solution in the presence of the substrate with barrier coating disposed thereon wherein a catalyst layer is disposed between the substrate and barrier coating. The metal ions are reduced at the surface of the catalyst layer exposed through defects in the barrier layer to form a repair coating comprising a metal. In some embodiments heat is applied to effect the reduction process.

In embodiments of the present invention the electroless plating process comprises a step of depositing a catalyst layer of material onto a substrate or onto a previously formed layer on a substrate, such as a planarizing layer. Illustrative examples of materials suitable for catalyst layers comprise those effective to reduce metal ions in solution to form a metal-comprising repair layer. In particular embodiments illustrative examples of materials suitable for catalyst layers comprise a noble metal, palladium, platinum, rhodium, or the like, or alloys thereof or any combination thereof. In other embodiments a precursor material may be disposed, followed by transformation of the precursor material to the active catalyst layer. Illustrative precursor materials comprise palladium-tin. The thickness of the catalyst layer is not particularly limited and is typically that thickness effective to permit electroless plating of at least one repair coating. In illustrative embodiments the thickness of the catalyst layer is in a range of about 10 nm to about 1000 nm, particularly in a range of about 10 nm to about 500 nm, and more particularly in a range of about 10 nm to about 150 nm. In particular embodiments the catalyst layer is such that said layer is substantially transparent, wherein the term "substantially transparent" is as defined herein below. In other particular embodiments the catalyst layer is such that the catalyst layer and substrate combination is substantially flexible. The catalyst layer may be applied using methods known in the art including, but not limited to, sputtering, thermal evaporation, electron beam evaporation, and like methods.

There is no particular limitation on the metal ions that may serve as the basis for the repair coating. Illustrative examples of metal ions include, but are not limited to, nickel, copper, or the like, or combinations thereof. In a particular embodiment suitable metal ions are nickel ion solutions, such as but not limited to, NIKLAD™ available from MacDermid Co., Waterbury CT. There is no particular limitation on the concentration of metal ions in solution provided that the solution may serve to provide a repair coating on the barrier coating in an electroless plating deposition process. Optimum values for these and other parameters associated with the electroless plating deposition process may be readily determined by those skilled in the art.

The electroless plating deposition process may be performed using methods known in the art, for example in a batch process, continuous process, or semi-continuous process. In a particular embodiment a continuous or semi-continuous roll-to-roll process is employed.

In some embodiments the composite article comprising the substrate, the barrier coating, and the repair coating may be substantially transparent for applications requiring transmission of light. In the present context the term "substantially transparent" means allowing a transmission of light in one embodiment of at least about 50 percent, in another embodiment of at least about 80 percent, and in still another embodiment of at least about 90 percent of light in a selected wavelength range. The selected wavelength range can be in the visible region, infrared region, ultraviolet region, or any combination thereof of the electromagnetic spectrum, and in particular embodiments wavelengths can be in the range from about 300 nm to about 10 micrometers. In another particular embodiment the composite article exhibits a light transmittance of greater than about 80% and particularly greater than about 85% in a selected wavelength range between about 400 nm to about 700 nm.

In typical embodiments the composite article is flexible and its properties do not significantly degrade upon bending. As used herein, the term "flexible" means being capable of being bent into a shape having a radius of curvature of less than about 100 centimeters.

Composite articles comprising substrate and barrier layer may be made by methods known in the art. In some embodiments composite articles may be made by a batch process, semi-continuous process, or continuous process. In one particular embodiment a composite article in embodiments of the invention may be made by a roll-to-roll process.

The composite article, according to embodiments of the invention, finds use in many devices or components such as, but not limited to, electroactive devices that are susceptible to reactive chemical species normally encountered in the environment. Illustrative electroactive devices comprise an electroluminescent device, a flexible display device including a liquid crystalline display (LCD), a thin film transistor LCD, a light emitting diode (LED), a light emitting device, an organic light emitting device (OLED), an optoelectronic device, a photovoltaic device, an organic photovoltaic device, an integrated circuit, a photoconductor, a photodetector, a chemical sensor, a biochemical sensor, a component of a medical diagnostic system, an electrochromic device, or any combination thereof. In another example the composite article as described in embodiments of the invention can advantageously be used in packaging of materials, such as food stuff, that are easily spoiled by chemical or biological agents normally existing in the environment.

Other embodiments of the invention comprise electroactive devices which comprise a composite article described in embodiments of the invention. In one illustrative example an electroactive device is a light emitting device comprising at least one organic electroluminescent layer sandwiched between two electrodes. The light emitting device further comprises a substrate and a barrier layer. The substrate may be flexible or substantially transparent, or both. The barrier layer comprises a barrier coating and a repair coating disposed on the barrier coating.

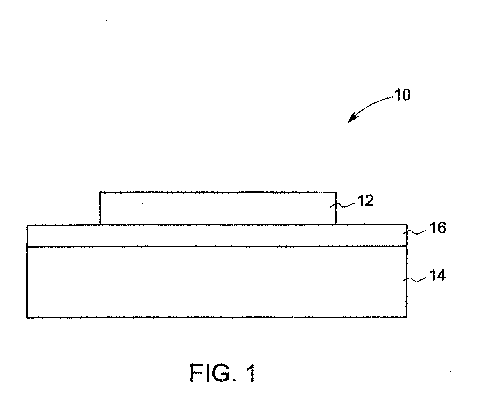

Figure 1 shows a composite article 10 in one embodiment of the invention. The composite article 10 comprises at least one organic electroluminescent layer 12 disposed on a substantially transparent substrate 14 and further comprises the barrier layer 16 disposed therein between as described above. The barrier layer 16 comprises a repair coating disposed on a barrier coating. For convenience in Figure 1 a conductive layer or catalyst layer positioned between the barrier coating and a surface to be protected, such as the substrate 14 or the organic electroluminescent layer 12, is not shown. The barrier layer 16 may be disposed or otherwise formed on either or both of the surfaces of the substrate 14 adjacent to the organic electroluminescent layer 12. In a particular embodiment the barrier layer 16 is disposed or formed on the surface of the substrate 14 adjacent to the organic electroluminescent layer 12. In other embodiments the barrier layer 16 may completely cover or encapsulate either the substrate 14 or the organic electroluminescent layer 12. In still other embodiments the barrier layer 16 may completely cover or encapsulate a composite article comprising a substrate 14 and an organic electroluminescent layer 12. In still other embodiments the barrier layer 16 may completely cover or encapsulate the device 10.

In a light emitting device comprising composite article 10, when a voltage is supplied by a voltage source and applied across the electrodes, light emits from the at least one organic electroluminescent layer 12. In one embodiment the first electrode is a cathode that may inject negative charge carriers into the organic electroluminescent layer 12. The cathode may be of a low work function material such as, but not limited to, potassium, lithium, sodium, magnesium, lanthanum, cerium, calcium, strontium, barium, aluminum, silver, indium, tin, zinc, zirconium, samarium, europium, alloys thereof, or the like, or mixtures thereof. The second electrode is an anode and is of a material having high work function such as, but not limited to, indium tin oxide, tin oxide, indium oxide, zinc oxide, indium zinc oxide, cadmium tin oxide, or the like, or mixtures thereof. The anode may be substantially transparent, such that the light emitted from the at least one organic electroluminescent layer 12 may easily escape through the anode. Additionally, materials used for the anode may be doped with aluminum species or fluorine species or like materials to improve their charge injection properties.

The thickness of the at least one organic electroluminescent layer 12 is typically in a range of about 50 nm to about 300 nm. The organic electroluminescent layer 12 may comprise a polymer, a copolymer, a mixture of polymers, or lower molecular weight organic molecules having unsaturated bonds. Such materials possess a delocalized pi-electron system, which gives the polymer chains or organic molecules the ability to support positive and negative charge carriers with high mobility. Mixtures of these polymers or organic molecules and other known additives may be used to tune the color of the emitted light. In some embodiments the organic electroluminescent layer 12 comprises a material selected from the group consisting of a poly(n-vinylcarbazole), a poly(alkylfluorene), a poly(paraphenylene), a polysilane, derivatives thereof, mixtures thereof, or copolymers thereof. In certain embodiments the organic electroluminescent layer 12 comprises a material selected from the group consisting of 1,2,3-tris[n-(4-diphenylaminophenyl) phenylaminobenzene, phenylanthracene, tetraarylethene, coumarin, rubrene, tetraphenylbutadiene, anthracene, perylene, coronene, aluminum-(picolylmethylketone)-bis[2,6-di(t-butyl)phenoxides], scandium-(4-methoxy-picolylmethylketone)-bis(acetylacetonate), aluminum acetylacetonate, gallium acetylacetonate, and indium acetylacetonate. More than one organic electroluminescent layer 12 may be formed successively one on top of another, each layer comprising a different organic electroluminescent material that emits in a different wavelength range.

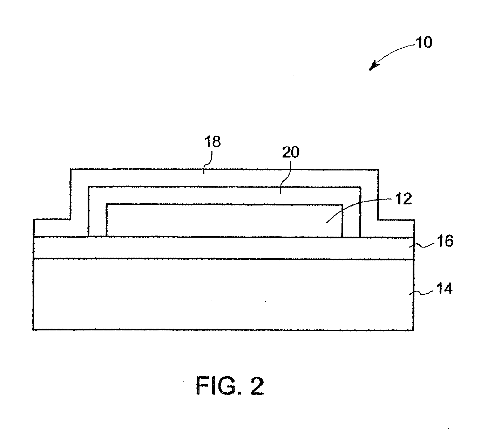

In some embodiments a reflective layer may be disposed on the organic electroluminescent layer to improve the efficiency of the device. Illustrative reflective layers comprise a material selected from the group consisting of a metal, a metal oxide, a metal nitride, a metal carbide, a metal oxynitride, a metal oxycarbide and combinations thereof. Figure 2 shows a composite article comprising layers including a reflective metal layer 18 which may be disposed on the organic electroluminescent layer 12 to reflect any radiation emitted from the substantially transparent substrate 14 and direct such radiation toward the substrate 14 such that the total amount of radiation emitted in this direction is increased. Suitable metals for the reflective metal layer 18 comprise silver, aluminum, alloys thereof, and the like. A barrier layer 16 may be disposed on either side of the substrate 14. The barrier layer 16 comprises a repair coating disposed on a barrier coating. For convenience in Figure 2 a conductive layer or catalyst layer positioned between the barrier coating and a surface to be protected, such as, but not limited to, the substrate 14 or the organic electroluminescent layer 12, is not shown. It may be desired to dispose the barrier layer 16 adjacent to the organic electroluminescent layer 12. The reflective metal layer 18 also serves an additional function of preventing diffusion of reactive environmental elements, such as oxygen and water vapor, into the organic electroluminescent layer 12. It may be advantageous to provide a reflective layer thickness that is sufficient to substantially prevent the diffusion of oxygen and water vapor, as long as the thickness does not substantially reduce the flexibility of composite article 10. In one embodiment of the present invention one or more additional layers of at least one different material, such as a different metal or metal compound, may be formed on the reflective metal layer 18 to further reduce the rate of diffusion of oxygen and water vapor into the organic electroluminescent layer 12. In this case the material for such additional layer or layers need not be a reflective material. Compounds, such as, but not limited to, metal oxides, nitrides, carbides, oxynitrides, or oxycarbides, may be useful for this purpose.

In another embodiment of the composite article 10 an optional bonding layer 20 of a substantially transparent organic polymeric material may be disposed on the organic electroluminescent layer 12 before the reflective metal layer 18 is deposited thereon, also shown in Figure 2. Examples of materials suitable for forming the organic polymeric layer comprise polyacrylates such as polymers or copolymers of acrylic acid, methacrylic acid, esters of these acids, or acrylonitrile; poly(vinyl fluoride); poly(vinylidene chloride); poly(vinyl alcohol); a copolymer of vinyl alcohol and glyoxal (also known as ethanedial or oxaldehyde); polyethylene terephthalate, parylene (thermoplastic polymer based on p-xylene), and polymers derived from cycloolefins and their derivatives (such as poly(arylcyclobutene) disclosed in U.S. Patent Nos. 4,540,763 and 5,185,391. In one embodiment the bonding layer 20 material is an electrically insulating and substantially transparent polymeric material.

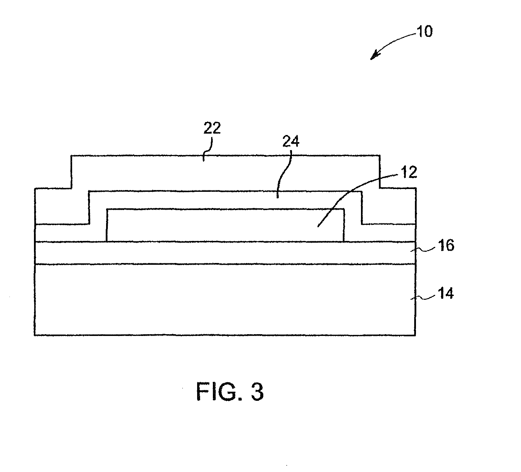

Figure 3 shows a composite article comprising layers in another embodiment of the invention. In particular in Figure 3 the composite article 10 comprises a second barrier layer 24 disposed on the organic electroluminescent layer 12 on the side away from the first substrate 14 to form a complete seal around the organic electroluminescent layer 12 wherein the second barrier layer 24 is disposed between the second substrate layer 22 and the electroluminescent layer 12. In some embodiments the second substrate 22 may comprise a polymeric material and particularly an organic polymeric material. The first barrier layer 16 may be disposed on either side of the first substrate 14. The barrier layer 16 comprises a repair coating disposed on a barrier coating. For convenience in Figure 3 a conductive layer or catalyst layer positioned between the barrier coating and a surface to be protected, such as, but not limited to, the substrate 14 or the organic electroluminescent layer 12, is not shown. In one embodiment the first barrier layer 16 is disposed adjacent to the organic electroluminescent layer 12. In an alternative embodiment a reflective metal layer 18 may be disposed between the second barrier layer 24 and the organic electroluminescent layer 12 to provide even more protection to organic electroluminescent layer 12, wherein the order of layers in a modified embodiment of Figure 3 comprises, respectively, second substrate 22, second barrier layer 24, reflective metal layer 18, organic electroluminescent layer 12, first barrier layer 16, and first substrate 14. An optional bonding layer 20 may be present between reflective metal layer 18 and electroluminescent layer 12. In another embodiment the second barrier layer 24 may be deposited directly on the organic electroluminescent layer 12 instead of being disposed on a second substrate 22. In this case, the second substrate 22 may be eliminated. In still another embodiment the second substrate 22 having the second barrier layer 24 can be disposed between organic electroluminescent layer 12 and the reflective metal layer 18, wherein the second substrate 22 is in contact with the reflective metal layer 18 and the second barrier layer 24 is in contact with the electroluminescent layer 12. An optional bonding layer 20 may be present between layers, for example between electroluminescent layer 12 and second barrier layer 24. This configuration may be desirable when it can offer some manufacturing or cost advantage, especially when the transparency of coated substrate is also substantial. The first barrier layer 16 and the second barrier layer 24 may be the same or different. The first substrate 14 and the second substrate 22 may be the same or different.

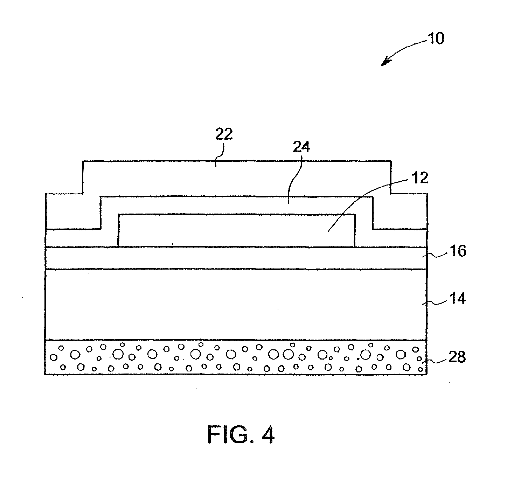

Figure 4 shows a composite article comprising layers in another embodiment of the invention. In Figure 4 the composite article 10 may further comprise a light scattering layer 28 disposed in the path of light emitted from a light emitting device comprising the composite article 10, and also comprising first substrate 14, first barrier layer 16, organic electroluminescent layer 12, second barrier layer 24, and second substrate 22. The barrier layer 16 comprises a repair coating disposed on a barrier coating. For convenience in Figure 4 a conductive layer or catalyst layer positioned between the barrier coating and a surface to be protected, such as, but not limited to, the substrate 14 or the organic electroluminescent layer 12, is not shown. An optional bonding layer 20 may be present between layers, for example between electroluminescent layer 12 and second barrier layer 24. The light scattering layer 28 typically comprises scattering particles of size in the range of from about 10 nm to about 100 micrometers. The scattering particles may be advantageously dispersed in a substantially transparent matrix disposed on the composite article. Illustrative light scattering materials comprise rutile, hafnia, zirconia, zircon, gadolinium gallium garnet, barium sulfate, yttria, yttrium aluminum garnet, calcite, sapphire, diamond, magnesium oxide, germanium oxide, or mixtures thereof. In some embodiments the light scattering layer 28 further comprises a photoluminescent material mixed with the scattering particles. The inclusion of such a photoluminescent material may provide a tuning of color of light emitted from a light emitting device comprising composite article 10. Many micrometer sized particles of oxide materials, such as zirconia, yttrium and rare-earth garnets, and halophosphates or like materials may be used. Illustrative photoluminescent material may be selected from the group consisting of (Y₁₋ₓCeₓ)₃ Al₅O₁₂; (Y_{1-x-y}GdₓCe_{y})₃ Al₅O₁₂; (Y₁₋ₓCeₓ)₃ (Al_{1-y}Ga_{y}) O₁₂; (Y_{1-x-y}GdₓCe_{y}) (Al_{5-z}Ga_{z})O₁₂; (Gd₁₋ₓ, Ceₓ)Sc₂Al₃O₁₂; Ca₈Mg(SiO₄)₄Cl₂:Eu²⁺,Mn²⁺; GdBO₃:Ce³⁺,Tb³⁺; CeMgAl₁₁O₁₉:Tb³⁺; Y₂SiO₅:Ce³⁺,Tb³⁺; BaMg₂Al₁₆O₂₇:Eu²⁺,Mn²⁺; Y₂O₃:Bi³⁺,Eu³⁺; Sr₂P₂O₇:Eu²⁺,Mn²⁺; SrMgP₂O₇:Eu²⁺,Mn²⁺; (Y,Gd)(V,B)O₄:Eu³⁺; 3.5MgO 0.5 MgF₂ GeO₂:Mn⁴⁺ (magnesium fluorogermanate); BaMg₂Al₁₆O₂₇:Eu²⁺; Sr₅(PO₄)₁₀Cl₂:Eu²⁺; (Ca,Ba,Sr)(Al,Ga)₂ S₄:Eu²⁺; (Ca, Ba, Sr)₅(PO₄)₁₀ (Cl,F)₂:Eu²⁺,Mn²⁺; Lu₃Al₅O₁₂:Ce³⁺; Tb₃Al₅O₁₂:Ce³⁺; and mixtures thereof; wherein 0 ≤ x ≤ 1, 0 ≤ y ≤ 1, 0 ≤ z ≤ 5 and x+y. ≤ 1. In some embodiments the light scattering layer 28 further comprises at least one organic photoluminescent material capable of absorbing at least a portion of electromagnetic radiation emitted by the organic electroluminescent layer 12 and emitting electromagnetic radiation in the visible range.

Furthermore, one or more additional layers may be included in any light emitting device comprising composite article 10 between one of the two electrodes and the organic electroluminescent layer 12 to perform at least one function selected from the group consisting of electron injection enhancement, hole injection enhancement, electron transport enhancement, and hole transport enhancement.

Barrier layers comprising barrier coating with repair coating in embodiments of the invention typically exhibit barrier properties which comprise a low water vapor transmission rate and a low oxygen transmission rate. In some embodiments barrier layers of the invention have a water vapor transmission rate in one embodiment of less than about 1x10⁻² grams per square meter per day (g/m²/day), and in another embodiment of less than about 1x10⁻⁴ g/m²/day, as measured at 25°C and with a gas having 50 percent relative humidity. Barrier layers of the invention have an oxygen transmission rate in one embodiment of less than about 0.1 cubic centimeters per square meter per day (cm³/m²/day), in another embodiment of less than about 0.5 cm³/m²/day, and in still another embodiment of less than about 1 cm³/m²/day as measured at 25°C and with a gas containing 21 volume percent oxygen. In some embodiments the barrier layers were tested for their barrier properties using the direct calcium test. This test is based on the reaction of calcium with water vapor and are described, for example, by A.G. Erlat et al. in "47th Annual Technical Conference Proceedings - Society of Vacuum Coaters", 2004, pp. 654-659, and by M.E. Gross et al. in "46th Annual Technical Conference Proceedings - Society of Vacuum Coaters", 2003, pp. 89-92. In a representative embodiment of the direct calcium test, a test sample is prepared by depositing a calcium layer over a substrate having a dimension of about 2.5 cm by 2.5 cm inside a glovebox having a specified water content of less than about 1 part per million and an oxygen content of less than about 5 parts per million. A barrier layer may be present between the substrate and calcium layer. The calcium layer is 100 nanometers thick with a diameter of about 9.5 millimeters. The test sample is sealed with a glass cover slip using a UV curable epoxy such as, ELC2500® (from Electro-Lite Corporation). The sealed test sample is removed from the glovebox and is placed in an automated imaging system for imaging and measuring the initial optical density. The test sample is imaged at every regular intervals over a period of time to evaluate the barrier performance of the substrate. In between measurements, the test sample is stored in an environmental chamber having a relative humidity of about 90%, at a temperature of about 60°C. The water vapor permeates through the defects in the substrate and comes in contact with the calcium layer to form calcium hydroxide in localized regions, and these localized regions expand laterally as a function of time which are recorded as multiple images spanning over the period of time. The slower the calcium is consumed, the better the barrier properties. Test samples having different barrier layers may be compared for barrier performance using this method by comparing the amount of time the barrier coating lasted and the area of calcium layer consumed during this period. The detection limit using this test is more than about 1500 hours.

Without further elaboration, it is believed that one skilled in the art can, using the description herein, utilize the present invention to its fullest extent. The following examples are included to provide additional guidance to those skilled in the art in practicing the claimed invention. The examples provided are merely representative of the work that contributes to the teaching of the present application. Accordingly, these examples are not intended to limit the invention, as defined in the appended claims, in any manner.

### COMPARATIVE EXAMPLES

A barrier layer was prepared over a substrate by depositing a repair coating over a barrier coating by atomic layer deposition (ALD) in accordance with an embodiment of the invention described in co-owned, copending application Serial No. 11/567,308 (GE docket no. 198217). A polycarbonate substrate of about 15.2 centimeters (cm) to about 16.5 cm long and a width of about 2.5 cm was coated with 3,4-epoxycyclohexylmethyl-3,4-epoxycyclohexylcarboxylate (CY) on opposing surfaces of the polycarbonate substrate to form a planarizing layer. A barrier coating was formed on one side of the polycarbonate substrate and over the planarizing layer by plasma coating a layer of silicon nitride. The silicon nitride coated substrate was mounted on an aluminum mounting plate after blowing it with nitrogen to remove any adhering impurities. The silicon nitride coated substrate was then introduced into an ALD chamber. The silicon nitride coated substrate was exposed to trimethyl aluminum at a temperature of about 120°C with substrate holder at a temperature of 191°C. The trimethyl aluminum was pulsed 2 times for 0.5 seconds each. Next, a container containing tris(tert-butoxy)silanol was opened into the deposition chamber for 15 seconds. The ALD chamber was then purged with nitrogen for about 240 seconds. The coated substrate was removed from the ALD chamber, and the thickness of the repair coating was measured and was found to be about 10 nanometers. The ALD cycle was repeated 2 to 6 times to prepare individual samples with increasing thickness of the repair coating. Each coated substrate was removed from the ALD chamber, and the thickness of the repair coating was measured. Individual control samples showed no barrier properties when the repair coating was deposited in various thicknesses on CY or on polycarbonate or polyamide without the accompanying SiN barrier coating. When the repair coating was deposited on the SiN barrier coated substrate, the repair coated samples outperformed separate control samples lacking the repair coating. More particularly, the best control sample lacking a repair coating endured only 192 hours of Direct Ca-test. The repair coated samples at 10, 20, 40, and 60 nm thickness endured over 622 hours on the same calcium test. At 622 hours, at least 25% of the calcium remained on each of the repair coated samples with the 60 nm repair coated sample having a thicker (darker) area of calcium than the 10 nm repair coated sample.

### EXAMPLE 1

This example serves to illustrate the fabrication of a sample with electrophoretically deposited repair coating. In these examples the TiO₂ source was colloidal titania of approximately 12-15 nm particle size in ethylene glycol dimethylether prepared as described in co-owned, copending application Serial No. 11/567,307 (GE docket no. 196332-1). The SiO₂ source was NYACOL® 2034DI, a colloidal silica comprising silica particles of approximately 20 nm size with pH of about 3 obtained from Nyacol Nano Technologies, Inc.

A polycarbonate substrate with a planarizing layer on opposing surfaces of the polycarbonate substrate was prepared in a hoop support. The planarizing layer comprised 3,4-epoxycyclohexylmethyl-3,4-epoxycyclohexylcarboxylate (CY). Subsequently a layer of indium tin oxide (ITO) was sputtered onto one surface of the substrate. The ITO layer was approximately 110 nm thick. A barrier coating was formed on top of the ITO layer by plasma coating a layer of silicon nitride. Small pieces of silicon wafer were used to mask areas on the ITO layer that would later be used as electrode contacts. A portion of the coated substrate larger than the cylinder O-ring (described below) was cut from the hoop using a fresh razor blade. A cylinder with O-ring bottom seal was placed over a portion of the coated substrate ensuring that at least a portion of the previously masked area was included within the cylinder area. For particles in acidic solutions such as NYACOL® 2034DI where the particles are positively charged, the negative electrode was attached to the exposed ITO surface that had been previously masked. The cylinder was held in place while the metal oxide solution or colloid was introduced into the cylinder. The counter electrode was typically a strip of stainless steel or stainless steel mesh about 0.64 cm x 3.2 cm in dimensions. The counter electrode was bent and positioned over the upper lip of the cylinder such that as much of the strip contacted the solution as possible while preventing the strip from contacting the SiN surface. A constant voltage of 2 volts was applied for a fixed period of time using a Keithly 2400 constant voltage variable current DC power supply with data recording capability. Typically during the deposition process the measured current decreased from its initial value as deposition thickness increased and the insulating property of the solution side of the ITO layer increased. The coated substrate was removed and rinsed with iso-propanol. In some examples tetraethoxy silane (TEOS) was spun onto the coated substrate surface following the rinse. Table 1 shows the type of repair coating, the voltage application time, and the results of the direct calcium test indicative of barrier properties. Duplicate samples were run in most examples.

**TABLE 1**

| Repair coating | Time (secs) | Direct Ca test (hours) |
|---|---|---|
| | | |
| SiO₂ | 5 | 325 |
| SiO₂ | 5 | 657 |
| SiO₂ | 10 | 420 |
| SiO₂ | 10 | 657 |
| SiO₂ | 30 | 325 |
| SiO₂ | 30 | 420 |
| | | |
| SiO₂/TEOS | 5 | 512 |
| SiO₂/TEOS | 5 | 512 |
| SiO₂/TEOS | 10 | 325 |
| SiO₂/TEOS | 10 | 512 |
| | | |
| TiO₂/TEOS | 5 | 325 |
| TiO₂/TEOS | 5 | 287 |
| TiO₂/TEOS | 10 | 996 |

The data in Table 1 show that the electrophoretically deposited repair coatings had improved barrier properties compared to samples lacking the repair coating in the comparative examples. In addition the electrophoretically deposited repair coatings had barrier properties comparable to those repair coatings deposited by ALD.

### EXAMPLE 2

This example serves to illustrate the fabrication of a sample a repair coating deposited by electroless plating. A substrate with a planarizing layer is provided. A catalyst layer of palladium is deposited onto the planarizing layer. A barrier coating is disposed on the catalyst layer to form a composite article. The composite article is exposed to a solution of nickel ions and treated in such a manner that a repair layer of nickel is disposed on the barrier coating. The barrier layer comprising barrier coating and repair coating exhibits better barrier properties as measured by decreased rate of permeation of water vapor than a corresponding composite article without repair coating.

While only certain features of the invention have been illustrated and described herein, many modifications and changes will occur to those skilled in the art. It is, therefore, to be understood that the appended claims are intended to cover all such modifications and changes as fall within the true spirit of the invention. All Patents and published articles cited herein are incorporated herein by reference.

For completeness, various aspects of the invention are now set out in the following numbered clauses.
1. A composite article comprising:
   (i) a substrate having a surface;
   (ii) either a conductive layer or a catalyst layer disposed on at least one surface of the substrate; and
   (iii) a barrier layer disposed on the conductive layer or catalyst layer;
   wherein the barrier layer comprises a barrier coating and at least one repair coating disposed on the barrier coating, wherein the repair coating comprises a metal or a metal based compound.
2. The composite article of clause 1, wherein the substrate comprises an organic polymeric resin, a glass, a metal, a ceramic, or any combination thereof.
3. The composite article of clause 2, wherein the organic polymeric resin comprises a polyethylene terephthalate, a polyacrylate, a polycarbonate, a silicone, an epoxy resin, a silicone-functionalized epoxy resin, a polyester, a polyimide, a polyetherimide, a polyethersulfone, a polyethylene naphthalate, a polynorbornene, or a poly(cyclic olefin).
4. The composite article of clause 1, wherein the conductive layer is selected from the group consisting of indium tin oxide, tin oxide, indium oxide, zinc oxide, cadmium oxide, alumimum oxide, gallium oxide, indium zinc oxide, tungsten oxide, molybdenum oxide, titanium oxide, vanadium oxide, aluminum, platinum, gold, silver, lanthanide series metals, an alloy thereof, and combinations thereof.
5. The composite article of clause 1, wherein the catalyst layer is selected from the group consisting of a noble metal, palladium, platinum, rhodium, an alloy thereof, and combinations thereof.
6. The composite article of clause 1, wherein the barrier coating is selected from the group consisting of organic materials, inorganic materials, ceramic materials, metals, and any combination thereof.
7. The composite article of clause 6, wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof.
8. The composite article of clause 1, wherein the metal comprises nickel or copper.
9. The composite article of clause 1, wherein the metal based compound is selected from the group consisting of a metal halide, a metal oxide, a metal sulfide, a metal nitride, a metal carbide, a metal boride, silica, titania, alumina, zirconia, and combinations thereof.
10. The composite article of clause 1, wherein the barrier layer has a water vapor transmission rate through the barrier layer of less than about 1x10⁻² g/m²/day, as measured at 25°C and with a gas having 50 percent relative humidity.
11. The composite article of clause 1, having a light transmittance of greater than about 80% in a selected wavelength range between about 400 nanometers to about 700 nanometers.
12. The composite article of clause 1, wherein the barrier layer encapsulates the substrate and one or more other layers.
13. The composite article of clause 1, further comprising at least one planarizing layer.
14. An electroactive device comprising the composite article of clause 1.
15. The electroactive device of clause 14, comprising a flexible display device, a liquid crystalline display (LCD), a thin film transistor LCD, an electroluminescent device, a light emitting diode, a light emitting device, an organic light emitting device, a photovoltaic device, an organic photovoltaic device, an integrated circuit, a photoconductor, a photodetector, an optoelectronic device, a chemical sensor, a biochemical sensor, a component of a medical diagnostic system, an electrochromic device, or any combination thereof.
16. The electroactive device of clause 14, which is encapsulated by the barrier layer.
17. A packaging material comprising the composite article of clause 1.
18. A method of making a composite article comprising the steps of:
   (i) providing a flexible substrate having a surface;
   (ii) depositing either a conductive layer or a catalyst layer on at least one surface of the substrate;
   (iii) depositing a barrier coating on the conductive layer or catalyst layer;
   (iv) and disposing a repair coating on the barrier coating by exposing the barrier coating to at least one metal ion or charged particle species in at least one electrophoretic deposition process cycle or at least one electroless plating process cycle.
19. The method of clause 18, wherein the conductive layer is selected from the group consisting of indium tin oxide, tin oxide, indium oxide, zinc oxide, cadmium oxide, alumimum oxide, gallium oxide, indium zinc oxide, tungsten oxide, molybdenum oxide, titanium oxide, vanadium oxide, aluminum, platinum, gold, silver, lanthanide series metals, an alloy thereof, and combinations thereof.
20. The method of clause 18, wherein the catalyst layer is selected from the group consisting of a noble metal, palladium, platinum, rhodium, an alloy thereof, and combinations thereof.
21. The method of clause 18, wherein the barrier coating is deposited using plasma enhanced chemical vapor deposition, radio frequency plasma enhanced chemical vapor deposition, expanding thermal plasma-enhanced chemical vapor deposition, sputtering, reactive sputtering, electron cyclotron resonance plasma-enhanced chemical vapor deposition, inductively coupled plasma-enhanced chemical vapor deposition, evaporation, atomic layer deposition, or any combination thereof.
22. The method of clause 18, wherein the metal ion species comprises nickel or copper ions.
23. The method of clause 18, wherein the charged particles species is selected from the group consisting of a metal halide, a metal oxide, a metal sulfide, a metal nitride, a metal carbide, a metal boride, silica, titania, alumina, zirconia, and combinations thereof.
24. The method of clause 18, which further comprises providing a planarizing layer on the substrate.
25. The method of clause 18, which employs a roll-to-roll process.
26. An article made by the method of clause 18.
27. A light emitting device comprising:
   (i) a flexible, substantially transparent substrate having a surface;
   (ii) either a conductive layer or a catalyst layer disposed on at least one surface of the substrate;
   (iii) a barrier layer disposed on the conductive layer or catalyst layer; and
   (iv) at least one organic electroluminescent layer disposed between two electrodes;
   wherein the barrier layer comprises a barrier coating and at least one repair coating disposed on the barrier coating, wherein the repair coating comprises a metal or a metal based compound deposited in at least one electrophoretic deposition process cycle or at least one electroless plating process cycle.
28. The light emitting device of clause 27, wherein the substrate comprises a polyethylene terephthalate, a polyacrylate, a polycarbonate, a silicone, an epoxy resin, a silicone-functionalized epoxy resin, a polyester, a polyimide, a polyetherimide, a polyethersulfone, a polyethylene naphthalate, a polynorbornene, or a poly(cyclic olefin).
29. The light emitting device of clause 27, wherein the conductive layer is selected from the group consisting of indium tin oxide, tin oxide, indium oxide, zinc oxide, cadmium oxide, alumimum oxide, gallium oxide, indium zinc oxide, tungsten oxide, molybdenum oxide, titanium oxide, vanadium oxide, aluminum, platinum, gold, silver, lanthanide series metals, an alloy thereof, and combinations thereof.
30. The light emitting device of clause 27, wherein the catalyst layer is selected from the group consisting of a noble metal, palladium, platinum, rhodium, an alloy thereof, and combinations thereof.
31. The light emitting device of clause 27, wherein the barrier coating is selected from the group consisting of organic materials, inorganic materials, ceramic materials, metals, and any combination thereof.
32. The light emitting device of clause 27, wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof.
33. The light emitting device of clause 27, wherein the metal comprises nickel or copper.
34. The light emitting device of clause 27, wherein the metal based compound is selected from the group consisting of a metal halide, a metal oxide, a metal sulfide, a metal nitride, a metal carbide, a metal boride, silica, titania, alumina, zirconia, and combinations thereof.
35. The light emitting device of clause 27, further comprising a reflective layer disposed on the organic electroluminescent layer, wherein the reflective layer comprises a material selected from the group consisting of metals, metal oxides, metal nitrides, metal carbides, metal oxynitrides, metal oxycarbides, or combinations thereof.
36. The light emitting device of clause 27, wherein the organic electroluminescent layer comprises a material selected from the group consisting of a poly(n-vinylcarbazole), a poly(alkylfluorene), a poly(paraphenylene), a polysilane, derivatives thereof, mixtures thereof, and copolymers thereof.
37. The light emitting device of clause 27, wherein the organic electroluminescent layer comprises a material selected from the group consisting of 1,2,3-tris[n-(4-diphenylaminophenyl) phenylamino] benzene, phenylanthracene, tetraarylethene, coumarin, rubrene, tetraphenylbutadiene, anthracene, perylene, coronene, aluminum-(picolylmethylketone)-bis[2,6-di(t-butyl)phenoxides], scandium-(4-methoxy-picolylmethylketone-bis(acetylacetonate), aluminum acetylacetonate, gallium acetylacetonate, and indium acetylacetonate.
38. The light emitting device of clause 27, further comprising a light scattering layer, wherein the light scattering layer comprises scattering particles dispersed in a transparent matrix.
39. The light emitting device of clause 38, wherein the light scattering layer further comprises a photoluminescent material mixed with the scattering particles, wherein the photoluminescent material is selected from the group consisting of (Y₁₋ₓCeₓ)₃ Al₅O₁₂; (Y_{1-x-y}GdₓCe_{y})₃ Al₅O₁₂; (Y₁₋ₓCeₓ)₃ (Al_{1-y}Ga_{y}) O₁₂; (Y_{1-x-y}GdₓCe_{y}) (Al_{5-z}Ga_{z})O₁₂; (Gd₁₋ₓ Ceₓ)Sc₂Al₃O₁₂; Ca₈Mg(SiO₄)₄Cl₂:Eu²⁺,Mn²⁺; GdBO₃:Ce³⁺,Tb³⁺; CeMgAl₁₁O₁₉:Tb³⁺; Y₂SiO₅:Ce³⁺,Tb³⁺; BaMg₂Al₁₆O₂₇:Eu²⁺,Mn²⁺; Y₂O₃:Bi³⁺,E³⁺; Sr₂P₂O₇:Eu²⁺,Mn²⁺; SrMgP₂O₇:Eu²⁺,Mn²⁺; (Y,Gd)(V,B)O₄:Eu³⁺; 3.5MgO 0.5 MgF₂ GeO₂:Mn⁴⁺ (magnesium fluorogermanate); BaMg₂Al₁₆O₂₇:Eu²⁺; Sr₅(PO₄)₁₀Cl₂:Eu²⁺; (Ca,Ba,Sr)(Al,Ga)₂ S₄:Eu²⁺; (Ca, Ba, Sr)₅(PO₄)₁₀ (Cl,F)₂:Eu²⁺,Mn²⁺; Lu₃Al₅O₁₂:Ce³⁺; Tb₃Al₅O₁₂:Ce³⁺; and mixtures thereof; wherein 0 ≤ x ≤ 1, 0 ≤ y ≤ 1, 0 ≤ z ≤ 5 and x+y. ≤ 1.
40. The light emitting device of clause 38, further comprising at least one organic photoluminescent material dispersed within the light scattering layer, wherein the organic photoluminescent material is capable of absorbing at least a portion of electromagnetic radiation emitted by the organic electroluminescent layer and emitting electromagnetic radiation in a visible range.
41. The light emitting device of clause 27, wherein the organic electroluminescent structure further comprises at least one additional layer disposed between one of the two electrodes and the organic electroluminescent layer, wherein the additional layer performs at least one function selected from the group consisting of electron injection enhancement, electron transport enhancement, hole injection enhancement, and hole transport enhancement.
42. The light emitting device of clause 27, which is encapsulated by the barrier layer.
43. A composite article comprising:
   (i) a substrate having a surface;
   (ii) either a conductive layer or a catalyst layer disposed on at least one surface of the substrate; and
   (iii) a barrier layer disposed on the conductive layer or catalyst layer;
   wherein the conductive layer is selected from the group consisting of indium tin oxide, tin oxide, indium oxide, zinc oxide, cadmium oxide, alumimum oxide, gallium oxide, indium zinc oxide, tungsten oxide, molybdenum oxide, titanium oxide, vanadium oxide, aluminum, platinum, gold, silver, lanthanide series metals, an alloy thereof, and combinations thereof;
   wherein the catalyst layer is selected from the group consisting of a noble metal, palladium, platinum, rhodium, an alloy thereof, and combinations thereof;
   wherein the barrier layer comprises a barrier coating and at least one repair coating disposed on the barrier coating, wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof; and
   wherein the repair coating comprises a metal selected from the group consisting of nickel and copper or a metal based compound selected from the group consisting of a metal halide, a metal oxide, a metal sulfide, a metal nitride, a metal carbide, a metal boride, silica, titania, alumina, zirconia, and combinations thereof;
   wherein the barrier layer has a water vapor transmission rate through the barrier layer of less than about 1x10⁻² g/m²/day, as measured at 25°C and with a gas having 50 percent relative humidity, and
   wherein the composite article has a light transmittance of greater than about 80% in a selected wavelength range between about 400 nanometers to about 700 nanometers.
44. An electroactive device or a packaging material comprising the composite article of clause 43.
45. A composite article comprising:
   (i) either a conductive layer or a catalyst layer; and
   (ii) a barrier layer disposed on the conductive layer or catalyst layer;
   wherein the conductive layer is selected from the group consisting of indium tin oxide, tin oxide, indium oxide, zinc oxide, cadmium oxide, alumimum oxide, gallium oxide, indium zinc oxide, tungsten oxide, molybdenum oxide, titanium oxide, vanadium oxide, aluminum, platinum, gold, silver, lanthanide series metals, an alloy thereof, and combinations thereof;
   wherein the catalyst layer is selected from the group consisting of a noble metal, palladium, platinum, rhodium, an alloy thereof, and combinations thereof;
   wherein the barrier layer comprises a barrier coating and at least one repair coating disposed on the barrier coating, wherein the repair coating comprises a metal or a metal based compound deposited on the barrier coating in at least one electrophoretic deposition process cycle or at least one electroless plating process cycle,
   wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof;
   wherein the repair coating comprises a metal selected from the group consisting of nickel and copper or a metal based compound selected from the group consisting of a metal halide, a metal oxide, a metal sulfide, a metal nitride, a metal carbide, a metal boride, silica, titania, alumina, zirconia, and combinations thereof; and
   wherein the barrier layer has a water vapor transmission rate through the barrier layer of less than about 1x10⁻² g/m²/day, as measured at 25°C and with a gas having 50 percent relative humidity.

## Claims

1. A composite article (10) comprising:
(i) a substrate (14) having a surface; and
(ii) either a conductive layer or a catalyst layer disposed on at least one surface of the substrate (14); and
(iii) a barrier layer (16) disposed on the conductive layer or catalyst layer,
wherein the barrier layer (16) comprises a barrier coating and at least one repair coating disposed on the barrier coating, wherein the repair coating comprises a metal or a metal based compound.

2. The composite article of claim 1, wherein the substrate (14) comprises an organic polymeric resin, a glass, a metal, a ceramic, or any combination thereof.

3. The composite article of claim 1 or claim 2, wherein the conductive layer is selected from the group consisting of indium tin oxide, tin oxide, indium oxide, zinc oxide, cadmium oxide, alumimum oxide, gallium oxide, indium zinc oxide, tungsten oxide, molybdenum oxide, titanium oxide, vanadium oxide, aluminum, platinum, gold, silver, lanthanide series metals, an alloy thereof, and combinations thereof.

4. The composite article of any preceding claim, wherein the catalyst layer is selected from the group consisting of a noble metal, palladium, platinum, rhodium, an alloy thereof, and combinations thereof.

5. The composite article of any preceding claim, wherein the barrier coating is selected from the group consisting of organic materials, inorganic materials, ceramic materials, metals, and any combination thereof.

6. The composite article of any preceding claim, wherein the metal comprises nickel or copper, and wherein the metal based compound is selected from the group consisting of a metal halide, a metal oxide, a metal sulfide, a metal nitride, a metal carbide, a metal boride, silica, titania, alumina, zirconia, and combinations thereof.

7. The composite article of any preceding claim, wherein the barrier layer (16) has a water vapor transmission rate through the barrier layer of less than about 1x10⁻² g/m²/day, as measured at 25°C and with a gas having 50 percent relative humidity.

8. An electroactive device comprising the composite article (10) of any preceding claim, wherein the electroactive device comprises a flexible display device, a liquid crystalline display (LCD), a thin film transistor LCD, an electroluminescent device, a light emitting diode, a light emitting device, an organic light emitting device, a photovoltaic device, an organic photovoltaic device, a photoconductor, a photodetector, an optoelectronic device, an integrated circuit, a chemical sensor, a biochemical sensor, a component of a medical diagnostic system, an electrochromic device, or any combination thereof.

9. The electroactive device of claim 8, which is encapsulated by the barrier layer (16).

10. A packaging material comprising the composite article (10) of any one of claims 1 to 7
